# EUROPEAN PATENT APPLICATION

(11) **EP 4 125 111 A1**
(43) Date of publication of application: **01.02.2023**
(21) Application number: 21188439.0
(22) Date of filing: 29.07.2021
(51) Int. Cl.: H01J 37/28

(54) **APPARATUS AND METHOD FOR DIRECTING CHARGED PARTICLE BEAM TOWARDS A SAMPLE**

(71) Applicant: ASML Netherlands B.V., 5500 AH Veldhoven (NL)
(72) Inventor: WIELAND, Marco, Jan-Jaco, 5500 AH Veldhoven (NL)
(74) Representative: ASML Netherlands B.V.

(57) **Abstract**

A charged particle beam apparatus for directing a charged particle beam to preselected locations of a sample surface is provided. The charged particle beam has a field of view of the sample surface. A charged-particle-optical arrangement is configured to direct a charged particle beam along a beam path towards the sample surface and to detect charged particles generated in the sample in response to the charged particle beam. A stage is configured to support and move the sample relative to the beam path. A controller is configured to control the charged particle beam apparatus so that the charged particle beam scans over a preselected location of the sample simultaneously with the stage moving the sample relative to the charged-particle-optical column along a route, the scan over the preselected location of the sample covering a part of an area of the field of view.

## Description

### TECHNICAL FIELD

The embodiments provided herein disclose a charged-particle beam apparatus, and more particularly improved apparatuses and methods for directing a charged particle beam towards a sample.

### BACKGROUND

When manufacturing semiconductor integrated circuit (IC) chips, undesired pattern defects, as a consequence of, for example, optical effects and incidental particles, inevitably occur on a substrate (i.e., wafer) or a mask during the fabrication processes, thereby reducing the yield. Monitoring the extent of the undesired pattern defects is therefore an important process in the manufacture of IC chips. More generally, the inspection or measurement of a surface of a substrate, or other object/material, is an important process during and after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons, or Auger electrons (collectively called "signal electrons"). The signal electrons may be emitted from the material structure of the sample. By scanning the primary electron beam as the probing spot over the sample surface, signal electrons may be emitted across the surface of the sample. By collecting these emitted signal electrons from the sample surface, a pattern inspection tool may obtain an image representing characteristics of the material structure of the sample.

A commonly used defect detection strategy is a two step process. In a first process a large area of the sample is measured using a bright field or optical inspection to flag likely defects. For a high capture rate at a small defect size, a high nuisance is accepted. In the second process all the flagged defects are reviewed using a review tool. Flagged defects that are verified as not being a defect are referred to as a 'nuisance' One such review process is known as "KLARF" inspection. Electron beam inspection tools, such as single beam inspection tools are commonly used for such review.

With increasingly tighter product specifications, the future nuisance count is expected to increase into the millions per sample. With commonly used settings the time it takes a single beam review tool to review a sample is expected to increase to an uncommercially unviable duration.

### SUMMARY

The embodiments provided herein disclose a charged-particle beam apparatus, and more particularly improved apparatuses and methods for directing a charged particle beam towards a sample. Such embodiments may provide review of a sample with an increased number and proportion of nuisances in a more acceptable time period.

One aspect of the present disclosure is directed to a charged particle beam apparatus for directing a charged particle beam to preselected locations of a sample surface, the charged particle beam having a field of view of the sample surface, comprising:
a charged-particle-optical arrangement configured to direct a charged particle beam along a beam path towards the sample surface and to detect charged particles generated in the sample in response to the charged particle beam;
a stage configured to support and move the sample relative to the beam path; and
a controller configured to control the charged particle beam apparatus so that the charged particle beam scans over a preselected location of the sample simultaneously with the stage moving the sample relative to the charged-particle-optical column long a route, the scan over the preselected location of the sample covering part of the area of the field of view.

Another aspect of the present disclosure is directed to A method for directing a charged particle beam to preselected locations of a sample surface, comprising:
directing a charged particle beam along a beam path towards a preselected location of a sample, the charged particle beam having a field of view of the sample;
moving the sample relative to the beam path; and
detecting charged particles emitted from the sample in response to the charged particle beam,
wherein the directing the charged particle beam comprises scanning the charged particle beam over a preselected location of the sample simultaneously with the sample being moved relative to the beam path along a route, the scanning over the preselected location covering a part of an area of the sample of the field of view

Another aspect of the present disclosure is directed to a charged particle beam apparatus for directing a charged particle beam to preselected locations on a sample surface, comprising:
- a charged-particle-optical arrangement configured to direct a charged particle beam along a beam path towards the sample surface and to detect charged particles generated in the sample in response to the charged particle beam;
- a stage configured to support and move the sample relative to the beam path; and
- a controller configured to control the charged particle beam apparatus so that the charged particle beam scans over the preselected locations of the sample simultaneously with the stage moving the sample relative to the beam path along a meandering route wherein the stage is moved continuously for multiple straight sections of the meandering route,
wherein at least two of the straight sections of the meandering route are parallel and the field of view has a length at least as long as a distance between adjacent straight sections in a direction perpendicular to the straight sections.

Another aspect of the present disclosure is directed to a charged particle beam apparatus for directing a charged particle beam to preselected locations on a sample surface comprising:
- a charged-particle-optical arrangement configured to direct a charged particle beam along a beam path towards the sample surface and to detect charged particles generated in the sample in response to the charged particle beam ;
- a stage configured to support and move the sample relative to the beam path; and
- controller configured to control the charged particle beam apparatus so that the charged particle beam scans over the preselected locations of the sample simultaneously with the stage moving the sample relative to the beam path along a route wherein the charged particle optical arrangement is configured to correct dynamically aberrations in the charged particle beam.

Another aspect of the present disclosure is directed to a charged particle beam apparatus for directing a charged particle beam to preselected locations of a sample surface, the charged particle beam having a field of view of the sample surface, comprising:
a charged-particle-optical arrangement configured to direct a charged particle beam along a beam path towards the sample surface and to detect charged particles generated in the sample in response to the charged particle beam;
a stage configured to support and move the sample relative to the beam path; and
a controller configured to control the charged particle beam apparatus so that the charged particle beam scans over a preselected location of the sample simultaneously with the stage moving the sample relative to the charged-particle-optical column along a route,
wherein the charged particle optical arrangement is configured to correct aberrations in the charged particle beam whilst scanning the charged particle beam over the preselected location of the sample.

Another aspect of the present disclosure is directed to a method for directing a charged particle beam to preselected locations of a sample surface, comprising:
directing a charged particle beam along a beam path towards a preselected location of a sample, the charged particle beam having a field of view of the sample;
moving the sample relative to the beam path; and
detecting charged particles emitted from the sample in response to the charged particle beam,
wherein the directing the charged particle beam comprises scanning the charged particle beam over a preselected location of the sample simultaneously with the sample being moved relative to the beam path along a meandering route wherein the stage is moved continuously for multiple straight sections of the meandering route,
wherein at least two of the straight sections of the meandering route are parallel and the field of view has a length at least as long as a distance between adjacent straight sections in a direction perpendicular to the straight sections.

Another aspect of the present disclosure is directed to a method for directing a charged particle beam to preselected locations of a sample surface, comprising:
directing a charged particle beam along a beam path towards a preselected location of a sample, the charged particle beam having a field of view of the sample;
moving the sample relative to the beam path; and
detecting charged particles emitted from the sample in response to the charged particle beam,
wherein the directing the charged particle beam comprises scanning the charged particle beam over a preselected location of the sample simultaneously with the sample being moved relative to the beam path along a route and dynamically correcting the charged particle beam for aberrations therein.

Other advantages of the embodiments of the present disclosure will become apparent from the following description taken in conjunction with the accompanying drawings wherein are set forth, by way of illustration and example, certain embodiments of the present disclosure.

### BRIEF DESCRIPTION OF FIGURES

FIG. 1 is a schematic diagram illustrating a charged-particle beam inspection system, consistent with embodiments of the present disclosure.
FIG. 2 is a schematic diagram illustrating an exemplary configuration of an electron beam tool that can be a part of the charged-particle beam inspection system of FIG. 1, consistent with embodiments of the present disclosure.
FIG. 3 is a schematic view of preselected locations within a field of view on a route across a sample.
FIG. 4 is a schematic diagram illustrating an exemplary configuration of an electron beam tool that can be a part of the charged-particle beam inspection system of FIG. 1, consistent with embodiments of the present disclosure.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations. Instead, they are merely examples of apparatuses and methods consistent with aspects related to the disclosed embodiments as recited in the appended claims. For example, although some embodiments are described in the context of utilizing electron beams, the disclosure is not so limited. Other types of charged particle beams may be similarly applied. Furthermore, other imaging systems may be used, such as optical imaging, photo detection, x-ray detection, etc.

Electronic devices are constructed of circuits formed on a piece of silicon called a substrate. Many circuits may be formed together on the same piece of silicon and are called integrated circuits or ICs. The size of these circuits has decreased dramatically so that many more of them can fit on the substrate. For example, an IC chip in a smart phone can be as small as a thumbnail and yet may include over 2 billion transistors, the size of each transistor being less than 1/1000th the size of a human hair.

Making these extremely small ICs is a complex, time-consuming, and expensive process, often involving hundreds of individual steps. Errors in even one step have the potential to result in defects in the finished IC, thereby rendering it useless. Thus, one goal of the manufacturing process is to avoid such defects to maximize the number of functional ICs made in the process, that is, to improve the overall yield of the process.

One component of improving yield is monitoring the chip making process to ensure that it is producing a sufficient number of functional integrated circuits. One way to monitor the process is to inspect the chip circuit structures at various stages of their formation. Inspection can be carried out using a scanning electron microscope (SEM). An SEM can be used to image these extremely small structures, in effect, taking a "picture" of the structures. The image can be used to determine if the structure was formed properly and also if it was formed in the proper location. If the structure is defective, then the process can be adjusted so the defect is less likely to recur.

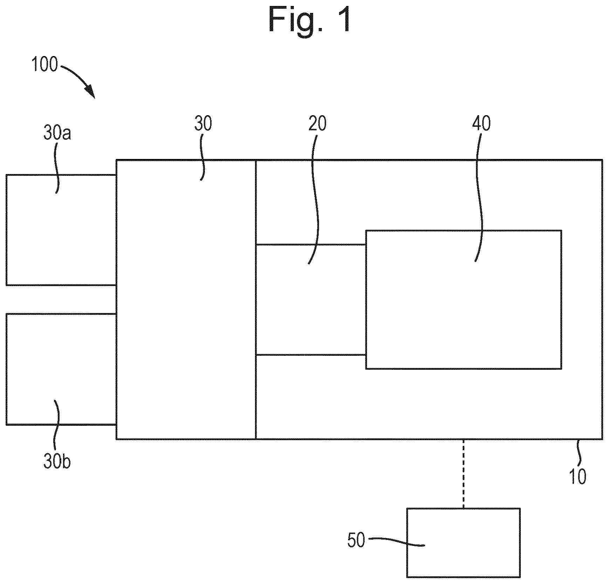

Reference is now made to FIG. 1, which illustrates an exemplary charged particle beam inspection system 100 such as an electron beam inspection (EBI) system, consistent with embodiments of the present disclosure. As shown in FIG. 1, the charged particle beam inspection system 100 includes a main chamber 10, a load-lock chamber 20, an electron beam tool 40, and an equipment front end module (EFEM) 30. The electron beam tool 40 is located within the main chamber 10. While the description and drawings are directed to an electron beam, it is appreciated that the embodiments are not used to limit the present disclosure to specific charged particles.

The EFEM 30 includes a first loading port 30a and a second loading port 30b. The EFEM 30 may include additional loading port(s). The first loading port 30a and the second loading port 30b receive wafer front opening unified pods (FOUPs) that contain wafers (e.g., semiconductor wafers or wafers made of other material(s)) or samples to be inspected (wafers and samples are collectively referred to as "wafers" hereafter). One or more robot arms (not shown) in the EFEM 30 transport the wafers to the load-lock chamber 20.

The load-lock chamber 20 is connected to a load/lock vacuum pump system (not shown), which removes gas molecules in the load-lock chamber 20 to reach a first pressure below the atmospheric pressure. After reaching the first pressure, one or more robot arms (not shown) transport the wafer from the load-lock chamber 20 to the main chamber 10. The main chamber 10 is connected to a main chamber vacuum pump system (not shown), which removes gas molecules in the main chamber 10 to reach a second pressure below the first pressure. After reaching the second pressure, the wafer is subject to inspection by the electron beam tool 40. In some embodiments, the electron beam tool 40 may comprise a single-beam inspection tool.

The controller 50 may be electronically connected to the electron beam tool 40 and may be electronically connected to other components as well. The controller 50 may be a computer configured to execute various controls of the charged particle beam inspection system 100. The controller 50 may also include processing circuitry configured to execute various signal and image processing functions. While the controller 50 is shown in FIG. 1 as being outside of the structure that includes the main chamber 10, the load-lock chamber 20, and the EFEM 30, it is appreciated that the controller 50 can be part of the structure.

While the present disclosure provides examples of the main chamber 10 housing an electron beam inspection system, it should be noted that aspects of the disclosure in their broadest sense, are not limited to a chamber housing an electron beam inspection system. Rather, it is appreciated that the foregoing principles may be applied to other chambers as well.

Embodiments are described below in the context of inspection of a sample. However, the embodiments may be applied in other processes, for example metrology.

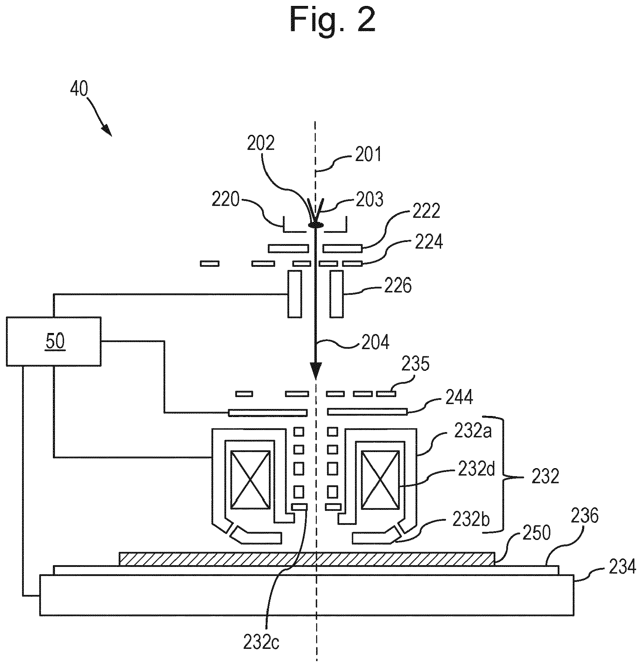

Reference is now made to FIG. 2, which is a schematic diagram illustrating an exemplary configuration of an electron beam tool 40 that can be a part of the charged particle beam inspection system 100 of FIG. 1, consistent with embodiments of the present disclosure. The electron beam tool 40 (also referred to herein as apparatus 40) may comprise an electron emitter, which may comprise a cathode 203, an anode 220, and a gun aperture 222. The electron beam tool 40 may further include a Coulomb aperture array 224, a condenser lens 226, a beam-limiting aperture array 235, an objective lens assembly 232, and an electron detector 244. The electron beam tool 40 may further include a sample holder 236 supported by a motorized stage 234 to hold a sample 250 to be inspected. It is to be appreciated that other relevant components may be added or omitted, as needed.

In some embodiments, the electron emitter may include cathode 203, an extractor anode 220, wherein primary electrons can be emitted from the cathode and extracted or accelerated to form a primary electron beam 204 that forms a primary beam crossover 202 (virtual or real). The primary electron beam 204 can be visualized as being emitted from the primary beam crossover 202.

In some embodiments, the electron emitter, condenser lens 226, objective lens assembly 232, beam-limiting aperture array 235, and electron detector 244 may be aligned with a primary optical axis 201 of the apparatus 40. In some embodiments, the electron detector 244 may be placed off the primary optical axis 201, along a secondary optical axis (not shown).

Objective lens assembly 232, in some embodiments, may comprise a modified swing objective retarding immersion lens (SORIL), which includes a pole piece 232a, a control electrode 232b, a deflector 232c (or more than one deflectors), and an exciting coil 232d. In a general imaging process, primary electron beam 204 emanating from the tip of cathode 203 is accelerated by an accelerating voltage applied to anode 220. A portion of primary electron beam 204 passes through gun aperture 222, and an aperture of Coulomb aperture array 224, and is focused by condenser lens 226 so as to fully or partially pass through an aperture of beam-limiting aperture array 235. The electrons passing through the aperture of beam-limiting aperture array 235 may be focused to form a probe spot on the surface of sample 250 by the modified SORIL lens and deflected to scan the surface of sample 250 by deflector 232c. Secondary electrons emanated from the sample surface may be collected by electron detector 244 to form an image of the scanned area of interest.

In the objective lens assembly 232, the exciting coil 232d and the pole piece 232a may generate a magnetic field that is leaked out through the gap between two ends of the pole piece 232a and distributed in the area surrounding the optical axis 201. A part of the sample 250 being scanned by the primary electron beam 204 can be immersed in the magnetic field and can be electrically charged, which, in turn, creates an electric field. The electric field may reduce the energy of the impinging primary electron beam 204 near and on the surface of the sample 250. The control electrode 232b, being electrically isolated from the pole piece 232a, controls the electric field above and on the sample 250 to reduce aberrations of the objective lens assembly 232 and control focusing situation of signal electron beams for high detection efficiency. The deflector 232c may deflect the primary electron beam 204 to facilitate beam scanning on the wafer. For example, in a scanning process, the deflector 232c can be controlled to deflect the primary electron beam 204, onto different locations of top surface of the sample 250 at different time points, to provide data for image reconstruction for different parts of the sample 250.

Backscattered electrons (BSEs) and secondary electrons (SEs) can be emitted from the part of the sample 250 upon receiving the primary electron beam 204. The electron detector 244 may capture the BSEs and SEs and generate image of the sample based on the information collected from the captured signal electrons. If the electron detector 244 is positioned off the primary optical axis 201, a beam separator (not shown) can direct the BSEs and SEs to a sensor surface of the electron detector 244. The detected signal electron beams can form corresponding secondary electron beam spots on the sensor surface of the electron detector 244. The electron detector 244 can generate signals (e.g., voltages, currents) that represent the intensities of the received signal electron beam spots, and provide the signals to a processing system, such as the controller 50. The intensity of secondary or backscattered electron beams, and the resultant beam spots, can vary according to the external or internal structure of the sample 250. Moreover, as discussed above, the primary electron beam 204 can be deflected onto different locations of the top surface of the sample 250 to generate secondary or backscattered signal electron beams (and the resultant beam spots) of different intensities. Therefore, by mapping the intensities of the signal electron beam spots with the locations of the primary electron beam 204 on the sample 250, the processing system can reconstruct an image of the sample 250 that reflects the internal or external structures of the sample 250.

In some embodiments, the controller 50 may comprise an image processing system that includes an image acquirer (not shown) and a storage (not shown). The image acquirer may comprise one or more processors. For example, the image acquirer may comprise a computer, server, mainframe host, terminals, personal computer, any kind of mobile computing devices, and the like, or a combination thereof. The image acquirer may be communicatively coupled to the electron detector 244 of the apparatus 40 through a medium such as an electrical conductor, optical fiber cable, portable storage media, IR, Bluetooth, internet, wireless network, wireless radio, among others, or a combination thereof. In some embodiments, the image acquirer may receive a signal from the electron detector 244 and may construct an image. The image acquirer may thus acquire images of regions of the sample 250. The image acquirer may also perform various post-processing functions, such as generating contours, superimposing indicators on an acquired image, and the like. The image acquirer may be configured to perform adjustments of brightness and contrast, etc. of acquired images. In some embodiments, the storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

In some embodiments, the controller 50 may include measurement circuitries (e.g., analog-to-digital converters) to obtain a distribution of the detected secondary electrons. The electron distribution data collected during a detection time window, in combination with corresponding scan path data of a primary beam 204 incident on the sample (e.g., a wafer) surface, can be used to reconstruct images of the wafer structures under inspection. The reconstructed images can be used to reveal various features of the internal or external structures of the sample 250, and thereby can be used to reveal any defects that may exist in the sample 250 (such as wafer).

In some embodiments, the controller 50 may control the motorized stage 234 to move the sample 250 during inspection. In some embodiments, the controller 50 may enable the motorized stage 234 to move the sample 250 in a direction continuously at a constant speed. In other embodiments, the controller 50 may enable the motorized stage 234 to change the speed of the movement of the sample 250 over time depending on the steps of scanning process.

Single beam inspection tools may be used to review flagged defects on a surface of a sample 250 determined by an optical defect inspection tool or that are flagged by predictive processes for example achieved by software, which may be referred to as 'computational prediction'. Thus, a flagged defect is at a known position on the sample surface and, with respect to the single beam inspection tool, may be at a preselected location 63. With improvements in feature specifications on a sample, the likely count of nuisances is likely to increase to several million, for example as much as twenty million nuisances for less than a thousand verified defects. A standard single beam tool can detect around ten thousand defects per hour. About half of this time is used for moving the stage, including settling time between move. Typically the time taken between flagged defects is less than 200 ms, preferably less than 150 ms. As the flagged defects are likely to be randomly positioned over the sample surface, review of all the flagged defects is expected to take long time, much longer than an hour.

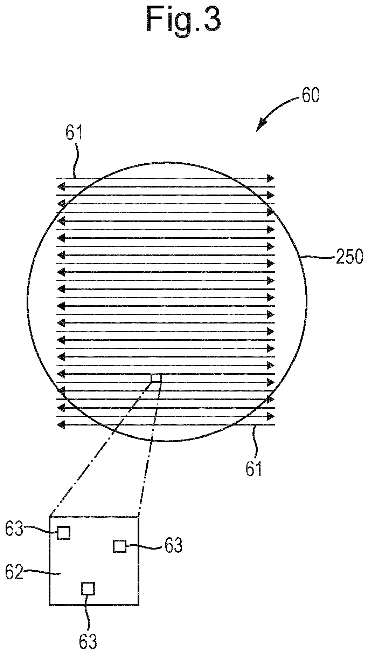

The present invention, as depicted in **FIG. 3**, is proposed to reduce the review time for the review of the sample 250. According an embodiment of the invention, the entire sample surface is systematically meandered under a field of view 62 of a single beam in a single electron beam tool. The meander follows a route 60 that scans across the sample surface. The route 60 features sections which cross the sample surface. The straight sections 61 are a distance apart which may be a common distance between all straight section 61. The distance between adjoining straight section 61 may be 50 to 200 micron for example 100 micron. During movement of the sample along at least the straight section 61, preferably two or more straight sections of the entire meander, the sample surface may be moved at constant velocity. Along the route 60, the single beam is scanned in X and Y to scan the preselected locations 63. In scanning the preselected locations 63, the single beam electron tool may acquire small micro SEM images. The surface of the sample 250 scanned at the preselected locations 63, and thus the acquired micro SEM images may be around 100 nm in dimension (e.g. 100nm x 100nm). Scanning such parts of the field of view 62 would pick up, and thus verify, defects about 20 nm in dimension or less. At an instance, there may be multiple flagged defects and thus predetermined locations 63 in the field of view 62 of the single beam. The single electron beam tool thus may be arranged to scan the single beam over the multiple predetermined locations 63 in the field of view 62.

The micro SEM image are acquired while the stage is continuously moving. For example, the stage may move the sample for example 100 micron while the image is acquired. So to acquire the beam is deflected to follow, e.g. track, the moving sample. This is a consequence of inspection of a limited part of the field of view. Therefore, a deflector, such as scan deflector 232c, may be controlled during the scanning of a preselected location 63 to counter act and accommodate the stage movement. The deflector operating on the beam to scan in the direction of the wafer stage movement, such as in the direction of straight section 61, would have a scan of greater magnitude than the dimension of the preselected location in the direction of movement. In an exemplary instance, three preselected locations 63 are present in one field of view 62. During the scanning of one of the three preselected locations the stage moves one third of the dimension of the field of view 62, for example one third of 100 micron, i.e. 33 microns. However, the dimension of the preselected location in the direction of stage movement is typically 100nm. Thus the position of the beam inside the field of view changes to counteract the wafer stage movement while scanning the pre-selected locations within the field of view.

The field of view may be relatively large. To counteract stage movement, the deflector operates on the beam so that it can reach all over the sample surface in the field of view. Such a large movement is likely to lead to induce off-axis aberrations such as focus aberrations, telecentric error (i.e. distortion) and astigmatism. The electron-optical components in the electron-optical column may be controlled to correct for these aberrations. Corrections may be made to the beam for focus and astigmatism for example as a function of deflector setting. Making the corrections increases the available field of view. In view of the continuous stage motion, the aberrations are corrected dynamically. Dynamic correction of aberrations means that the aberrations are corrected whilst scanning.

With this arrangement, the range of the stage and e-beam scanning settings should enable the entire distance between sections across the sample surface to be covered. All preselected locations 63 may be scanned. All flagged defects may be reviewed, Thus the arrangement enables the required SEM images at the preselected locations 63 to be made during the continuous scanning. The review of the flagged defects on a sample surface may therefore be achieved in less time that current arrangements.

In a variation, multi electron-beam inspection tool could be used instead of optical inspection to flag defects. In another variation, a multi-beam inspection tool is used to review flagged defects.

In an embodiment of the invention there is provided: a charged particle beam apparatus for directing a charged particle beam to preselected locations of a sample surface. The charged particle beam has a field of view 62 of the sample surface. The charged particle beam apparatus comprises a charged-particle-optical arrangement, a stage and a controller. The charged-particle-optical arrangement is configured to direct a charged particle beam along a beam path towards the sample surface. The charged-particle-optical arrangement is configured to detect charged particles generated in the sample in response to the charged particle beam. The stage may be configured to support and move the sample relative to the beam path. The controller configured to control the charged particle beam apparatus so that the charged particle beam scans over a preselected location 63of the sample. The scan over the preselected location 63is simultaneous with the stage moving the sample. The movement of the sample is relative to the charged-particle-optical column along a route 60. The scan over the preselected location of the sample covers, a fraction, or part of an area, of the field of view 62.

The charged-particle-optical arrangement may comprises a charged-particle-optical column configured to direct the charged particle beam along the beam path towards the sample. The charged-particle-optical arrangement may comprises a deflector arrangement configured to scan the charged particle beam over the preselected location of the sample.

The charged-particle-optical arrangement may comprise a lens arrangement. The lens arrangement may be configured to control a focus of the charged particle beam. The lens arrangement may be controllable to compensate for off-axis aberrations whilst scanning over the preselected location of the sample. The charged-particle-optical arrangement may comprise a charged-particle-optical component controllable to compensate for astigmatic aberrations generated whilst scanning over the preselected location of the sample. The charged-particle-optical arrangement may be configured to generate a signal on detection of a charged particle. The signal may be used to generate an image.

The stage may be configured to move continuously, preferably for multiple straight section 61 of the route 60. The controller may be configured to control the charged particle beam apparatus so that the charged particle beam is incident on any location of the sample. The charged particle beam may be incident on any location of the sample so as to generate images of preselected locations of the sample. The charged particle beam may be incident on preselected locations of the sample, for example to generate images of the preselected locations of the sample, preferably in order to verify flagged locations as defects. The area of the sample covered by the charged particle beam may be different for different preselected locations. The field of view 62 may comprise multiple preselected locations.

The controller is configured to control the stage to move the sample in a meandering path relative to the charged-particle-optical arrangement along a meandering route 60. The meandering route 60 comprises a plurality of straight section 61. At least two of the straight section 61 are parallel. The straight section 61 may extend across the sample. The field of view 62 may have a length at least as long as a distance between adjacent straight section 61 in a direction perpendicular to the straight section 61.

The stage is configured to move the sample relative to the charged-particle-optical arrangement at different speeds for different straight section 61 and/or within a straight section. The stage speed set for a straight section, or a portion of a straight section, is dependent on the number of preselected locations along the straight section or portion of the straight section. The stage is configured to move the sample relative to the charged-particle-optical arrangement at a constant speed for a straight section or for a portion of a straight section. The stage is configured to move the sample relative to the charged-particle-optical arrangement at a constant speed for at least a part of the route 60.

The charged particle beam apparatus configured to direct a plurality of charged particle beams towards the sample. The charged particle beams are independently controllable to simultaneously scan over different preselected locations of the sample.

The preselected locations are determined (or flagged) by optical defect inspection and/or defect prediction. The controller is configured to accept a data file or data signal comprising the preselected locations of a sample. The controller is configured control the stage and the charged particle arrangement based on the data comprised in the data file or data signal.

In another embodiment of the invention there is provided a method for directing a charged particle beam to preselected locations of a sample surface, comprising: directing, moving, and detecting. In the directing, directing a charged particle beam along a beam path towards a preselected location of a sample. The charged particle beam has a field of view 62 of the sample. In the moving, moving the sample relative to the beam path. In the detecting, detecting charged particles emitted from the sample in response to the charged particle beam. The directing the charged particle beam comprises scanning the charged particle beam over a preselected location of the sample. The scanning of the charged particle beam is simultaneous with the sample being moved relative to the beam path along a route 60. The scanning over the preselected location covers an area of the sample that is a fraction or a part of the area of the field of view 62.

The charged particle beam may be directed along the beam path by a charged-particle-optical arrangement. The charged-particle-optical arrangement may comprise a charged-particle-optical column configured to direct the charged particle beam along the beam path towards the sample. The method may comprise using a deflector arrangement to scan the charged particle beam over the preselected location of the sample.

The method may comprise using a lens arrangement to control a focus of the charged particle beam. The method may comprise controlling the lens arrangement to compensate for off-axis aberrations whilst scanning over the preselected location of the sample. The method may comprise controlling a charged-particle-optical component to compensate for astigmatic aberrations. The compensation for astigmatic aberrations may be generated whilst scanning over the preselected location of the sample. The method may comprise generating a signal on detection of a charged particle. The signal may be used to generate an image.

The method may comprise moving the sample continuously. The continuous movement may be for multiple straight section 61 of the route 60.

The method the charged particle beam may be incident on the sample so as to generate images of preselected locations of the sample. The images that are generated may be in order to verify flagged locations as defects. The area of the sample covered by the charged particle beam is different for different preselected locations. A size of a preselected location that is scanned over may be determined based on an amount of time that a field of view 62 of the sample containing a preselected location is reachable by the charged particle beam or a number of preselected locations in the field of view 62 or both. The field of view 62 may comprise multiple preselected locations.

The method may comprise moving the sample in a meandering path relative to the beam path along a meandering route 60. The meandering route 60 may comprise a plurality of straight section 61. The meandering route 60 may comprise at least two straight section 61 that are parallel. The straight section 61 may extend across the sample. The method field of view 62 may have a length at least as long as a distance between adjacent straight section 61 in a direction perpendicular to the straight section 61. The sample may be moved relative to the beam path at different speeds for different straight section 61 and/or within a straight section. The stage speed set for a straight section, or a portion of a straight section, may be dependent on the number of preselected locations along the straight section or portion of the straight section. The sample may be moved relative to the beam path at a constant speed for a straight section or for a portion of a straight section. The sample may be moved relative to the beam path at a constant speed for at least a part of the route 60.

The method may comprise directing a plurality of charged particle beams towards the sample. The charged particle beams may be independently controlled to simultaneously scan over different preselected locations of the sample.

The method may comprise: optically illuminating the sample. The optical illuminating the sample may be to select the locations of the sample to be scanned over by the charged particle beam. The selected locations may be said preselected locations. The method may comprise: storing the preselected locations. The preselected locations may be stored in a data file to be uploaded to a charged particle beam apparatus. The charged particle beam apparatus may be configured to direct a charged particle beam to the preselected locations stored in the data file.

In another embodiment of the invention there is provided a charged particle beam apparatus for directing a charged particle beam to preselected locations on a sample surface, comprising: a charged-particle-optical arrangement, a stage and a controller. The a charged-particle-optical arrangement is configured to direct a charged particle beam along a beam path towards the sample surface and to detect charged particles generated in the sample in response to the charged particle beam. The stage is configured to support and move the sample relative to the beam path. The controller is configured to control the charged particle beam apparatus so that the charged particle beam scans over the preselected locations of the sample simultaneously with the stage moving the sample relative to the beam path along a route wherein the stage is moved continuously.

The charged particle optical arrangement ,may be configured to correct dynamically aberrations in the charged particle beam. The charged particle optical arrangement may be configured to correct dynamically aberrations in the charged particle beam when scanning the different preselected locations. When scanning different preselected locations, the aberration correction applied to the beam is different. The charged particle optical arrangement may be configured to correct aberrations dynamically in the charged particle beam in order to counter act the wafer stage movement as the beam substantially moves through the field of view

A charged particle beam apparatus for directing a charged particle beam to preselected locations on a sample surface comprising: a charged-particle-optical arrangement, a stage and a controller. The charged-particle-optical arrangement is configured to direct a charged particle beam along a beam path towards the sample surface and to detect charged particles generated in the sample in response to the charged particle beam. The stage is configured to support and move the sample relative to the beam path. The controller is configured to control the charged particle beam apparatus so that the charged particle beam scans over the preselected locations of the sample simultaneously with the stage moving the sample relative to the beam path along a route. The charged particle optical arrangement is configured to correct dynamically aberrations in the charged particle beam.

The charged particle optical arrangement is configured to correct dynamically aberrations in the charged particle beam when scanning the different preselected locations. When scanning different preselected locations, the aberration correction applied to the beam is different. The charged particle optical arrangement may be configured to correct aberrations dynamically in the charged particle beam so as to counter act the wafer stage movement as the beam substantially moves through the field of view. The charged particle beam has a field of view corresponding to a portion of the sample surface. A charged particle scan over each preselected location of the sample covers at least a part of the field of view.

As mentioned above, the field of view 62 may be relatively large. To counteract stage movement, the deflector operates on the beam so that it can reach all over the sample surface in the field of view 62. Such a large movement is likely to lead to induce off-axis aberrations such as field curvature, telecentric error (i.e. distortion) and astigmatism. The electron-optical components in the electron-optical column may be controlled to correct for these aberrations dynamically.

In an embodiment the charged particle optical arrangement is configured to correct aberrations dynamically in the charged particle beam. In an embodiment the charged particle optical arrangement is configured to correct aberrations dynamically in the charged particle beam when scanning the different preselected locations 63. In an embodiment the aberrations that the charged particle optical arrangement is configured to correct dynamically comprise off-axis aberrations whilst scanning over the preselected locations 63. In an embodiment the charged-particle-optical arrangement comprises a lens arrangement configured to control a focus of the charged particle beam for correcting aberrations dynamically in the charged particle beam.

Off-axis aberrations vary as a function of position in the field of view 62. For example, the vertical position at which focus is optimal is different depending on position within the field of view 62. This may be known as a field curvature aberration. In an embodiment the field curvature aberration is compensated for by controlling a strength of a lens of the lens arrangement as a function of position in the field of view 62. In an embodiment the strength of a lens is controlled by controlling a voltage applied to a lens electrode. For example, the lens may comprise a one pole electrode. The strength of the lens depends on the voltage applied to the one pole electrode. In an embodiment the controller 50 is configured to control a voltage applied to the lens electrode so as to compensate for field curvature.

In an embodiment the lens may comprise an electrostatic part and a magnetic part. The strength of the lens can be controlled by controlling the electrostatic part, the magnetic part or both the electrostatic part and the magnetic part. In an embodiment, the voltage applied to the electrostatic part (e.g. lens electrode) is varied so as to vary the strength of the lens. By varying the electrostatic part, the strength of the lens can be controlled more quickly. In an alternative embodiment, the voltage applied to magnetic coils of the magnetic part of the lens is varied. When the magnetic part is varied, there may be a greater delay between the voltage change and the change in strength of the lens.

In an embodiment, astigmatism is compensated for by controlling a stigmator. The stigmator is configured to focus in one direction while defocusing in another (e.g. perpendicular direction). For example, the two directions may by the radial direction and the azimuthal direction within the field of view 62. The stigmator is configured to correct for astigmatism.

In an embodiment the stigmator comprises a multi-pole. For example in an embodiment the stigmator comprises a four-pole or an eight-pole, or a multi-pole with a number of poles having a factor of four. In an alternative embodiment the stigmator comprises slit lenses.

In an embodiment, the stigmator is controlled dynamically. This means that the stigmator is adjusted whilst scanning through the field of view 62. The input parameters for the stigmator are varied as a function of position within the field of view 62. In an embodiment a lookup table is provided comprises a list of stigmator settings for different positions in the field of view 62. The lookup table may be generated during a calibration process before performing a scan.

In an embodiment the settings of the stigmator comprise voltages applied to the poles of the multi-pole. In an embodiment the settings of the stigmator comprise voltages applied to electrodes of one or more slit lenses. In an embodiment the controller 50 is configured to control voltages applied to the stigmator as a function of position in the field of view 62.

In an embodiment the stigmator comprises an electrostatic part and a magnetic part. In an embodiment the electrostatic part of the stigmator is varied while the magnetic part is kept stable. This allows the effect of the stigmator on the beam to be changed rapidly whilst the beam scans throughout the field of view 62.

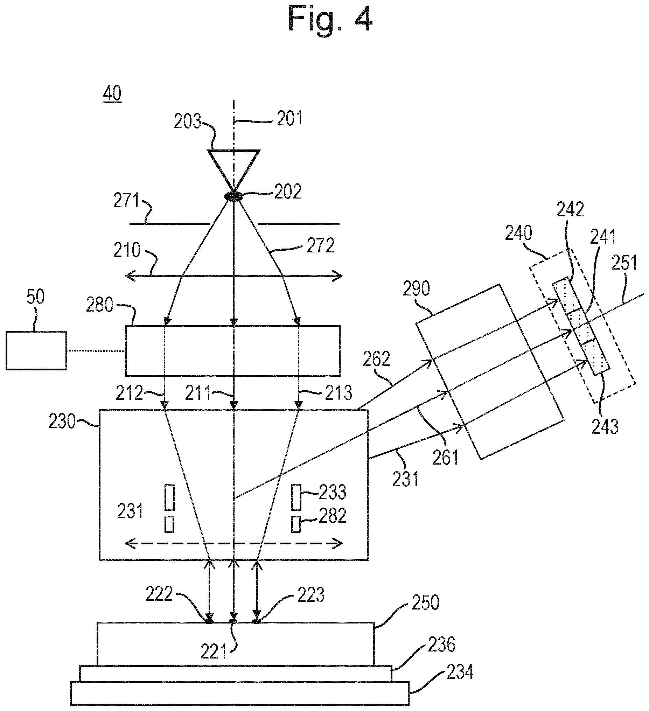

As mentioned above, in some embodiments, the electron beam tool 40 may comprise a single-beam inspection tool. In some embodiments, the electron beam tool 40 may comprise a multi-beam inspection tool. **FIG. 4** schematically depicts a multi-beam inspection tool consistent with embodiments of the invention.

Reference is now made to **FIG. 4**, which is a schematic diagram illustrating an exemplary electron beam tool 40 including a multi-beam inspection tool that is part of the exemplary charged particle beam inspection system 100 of **FIG. 1**. Some of the features of the electron beam tool 40 are the same as the features shown in **FIG. 2** and described above. For conciseness, these features are not described in detail below.

The multi-beam electron beam tool 40 comprises a cathode 203, a gun aperture plate 271, a condenser lens 210, a source conversion unit 280, a primary projection apparatus 230, a motorized stage 234, and a sample holder 236. The cathode 203, the gun aperture plate 271, the condenser lens 210 and the source conversion unit 280 are the components of an illumination apparatus comprised by the multi-beam electron beam tool 40. The sample holder 236 is supported by the motorized stage 234 so as to hold a sample 250 (e.g., a substrate or a mask) for inspection. The multi-beam electron beam tool 40 may further comprise a secondary projection apparatus 290 and an associated electron detection device 240. The primary projection apparatus 230 may comprise an objective lens 231. The electron detection device 240 may comprise a plurality of detection elements 241, 242, and 243. A beam separator 233 and a deflection scanning unit 282 may be positioned inside the primary projection apparatus 230.

The components that are used to generate a primary beam may be aligned with a primary electron-optical axis 201 of the electron beam tool 40. These components may include: the cathode 203, the gun aperture plate 271, the condenser lens 210, the source conversion unit 280, the beam separator 233, the deflection scanning unit 282, and the primary projection apparatus 230. The secondary projection apparatus 290 and its associated electron detection device 240 may be aligned with a secondary electron-optical axis 251 of the electron beam tool 40.

The primary electron-optical axis 204 is comprised by the electron-optical axis of the of the part of electron beam tool 40 that is the illumination apparatus. The secondary electron-optical axis 251 is the electron-optical axis of the of the part of electron beam tool 40 that is a detection apparatus. The primary electron-optical axis 204 may also be referred to herein as the primary optical axis (to aid ease of reference) or charged particle optical axis. The secondary electron-optical axis 251 may also be referred to herein as the secondary optical axis or the secondary charged particle optical axis.

The formed primary electron beam 272 may be a single beam and a multi-beam may be generated from the single beam. At different locations along the beam path, the primary electron beam 272 may therefore be either a single beam or a multi-beam. By the time it reaches the sample 250, and preferably before it reaches the primary projection apparatus 230, the primary electron beam 272 is a multi-beam. Such a multi-beam may be generated from the primary electron beam in a number of different ways. For example, the multi-beam may be generated by a multi-beam array located before the cross-over 202, a multi-beam array located in the source conversion unit 280, or a multi-beam array located at any point in between these locations. A multi-beam array may comprise a plurality of electron beam manipulating elements arranged in an array across the beam path. Each manipulating element may influence at least part of the primary electron beam to generate a sub-beam. Thus the multi-beam array interacts with an incident primary beam path to generate a multi-beam path down-beam of the multi-beam array. The interaction of the multi-beam array with the primary beam may include one or more aperture arrays, individual deflectors e.g. per sub-beam, lenses, stigmators and (aberration) correctors, again e.g. per sub-beam.

The gun aperture plate 271, in operation, is configured to block off peripheral electrons of primary electron beam 272 to reduce Coulomb effect. The Coulomb effect may enlarge the size of each of probe spots 221, 222, and 223 of the primary sub-beams 211, 212, 213, and therefore deteriorate inspection resolution. A gun aperture plate 271 may also include multiple openings for generating primary sub-beams (not shown) even before the source conversion unit 280 and may be referred to as a coulomb aperture array.

The condenser lens 210 is configured to focus (or collimate) primary electron beam 272. In an embodiment of the source conversion unit 280, the source conversion unit 280 may comprise an image-forming element array, an aberration compensator array, a beam-limit aperture array, and a pre-bending micro-deflector array. The pre-bending micro-deflector array may, for example, be optional and may be present in an embodiment in which the condenser lens does not ensure substantially normal incidence of sub-beams originating from the coulomb aperture array onto e.g. the beam-limit aperture array, the image-forming element array, and/or the aberration compensator array. The image-forming element array may be configured to generate the plurality of sub-beams in the multi-beam path, i.e. primary sub-beams 211, 212, 213. The image forming element array may, for example, comprise a plurality electron beam manipulators such as micro-deflectors micro-lenses (or a combination of both) to influence the plurality of primary sub-beams 211, 212, 213 of primary electron beam 202 and to form a plurality of parallel images (virtual or real) of primary beam crossover 203, one for each of the primary sub-beams 211, 212, and 213. The aberration compensator array may, for example, comprise a field curvature compensator array (not shown) and an astigmatism compensator array (not shown). The aberration compensator elements in the aberration compensator array may be individually controllable. The aberration compensator elements may be controlled dynamically. The sub-beams may be controllable independently of each other for example by the aberration compensator elements which may be individually and/or independently controllable. The field curvature compensator array may, for example, comprise a plurality of micro-lenses to compensate field curvature aberrations of the primary sub-beams 211, 212, and 213. The astigmatism compensator array may comprise a plurality of micro-stigmators to compensate astigmatism aberrations of the primary sub-beams 211, 212, and 213. The beam-limit aperture array may be configured to define the diameters of individual primary sub-beams 211, 212, and 213. **FIG. 4** shows three primary sub-beams 211, 212, and 213 as an example, and it should be understood that source conversion unit 280 may be configured to form any number of primary sub-beams. The controller 50 may be connected to various parts of charged particle beam inspection system 100 of **FIG. 1****,** such as the source conversion unit 280, the electron detection device 240, the primary projection apparatus 230, or the motorized stage 234. As explained in further detail below, the controller 50 may perform various image and signal processing functions. The controller 50 may also generate various control signals to govern operations of the charged particle beam inspection system 100.

In an embodiment the controller 50 is configured to control the stigmator(s) as a function of the position of the beams within the field of view so as to correct for astigmatism. That is compensator elements such as the micro-stigmators may comprise a multi-pole. Each multi-pole may be associated with a specific sub-beam. The multi-pole may be a series of electrodes arranged around an aperture for passage of the sub-beam. The number of electrodes or poles of the multi-pole may be a factor of four, so for example a four-pole or an eight-pole, or twelve-pole or twenty-pole. Each pole of a multi-pole may be individually controllable. Each stigmator and thus optionally each pole of the stigamator may be dynamically controllable. Each stigmator and optionally each pole of the stigamtor may be may be individually and/or independently controllable. The multi-pole may dynamically correct aberrations of its associated beam, for example as a function of the position of the beams within the field of view so as to correct for astigmatism.

The condenser lens 210 may further be configured to adjust electric currents of primary sub-beams 211, 212, 213 down-beam of source conversion unit 220 by varying the focusing power (collimating power) of the condenser lens 210. In an embodiment the controller 50 is configured to control the focusing power of the condenser lens 210 and/or one or more other lenses as a function of the position of the beams within the field of view so as to correct for field curvature. Alternatively, or additionally, the electric currents of the primary sub-beams 211, 212, 213 may be changed by altering the radial sizes of beam-limit apertures within the beam-limit aperture array corresponding to the individual primary sub-beams.

The objective lens 231 may be configured to focus sub-beams 211, 212, and 213 onto the sample 250 for inspection and, in the current embodiment, may form three probe spots 221, 222, and 223 on the surface of the sample 250.

The beam separator 233 may be, for example, a Wien filter comprising an electrostatic dipole field and a magnetic dipole field (not shown in **FIG. 4**). The deflection scanning unit 282, in operation, is configured to deflect primary sub-beams 211, 212, and 213 to scan probe spots 221, 222, and 223 across individual scanning areas in a section of the surface of the sample 250. In an embodiment the controller 50 is configured to control the beam separator 233 and/or the deflection scanning unit 282 as a function of the position of a beam within the field of view so as to correct for coma.

In response to incidence of primary sub-beams 211, 212, and 213 or probe spots 221, 222, and 223 on the sample 250, electrons are generated from the sample 208 which include secondary electrons and backscattered electrons. The beam separator 233 is arranged to deflect the path of the secondary electron beams 261, 262, and 263 towards the secondary projection apparatus 290. The secondary projection apparatus 290 subsequently focuses the path of secondary electron beams 261, 262, and 263 onto a plurality of detection regions 241, 242, and 243 of electron detection device 240. The detection regions may, for example, be the separate detection elements 241, 242, and 243 that are arranged to detect corresponding secondary electron beams 261, 262, and 263. The detection regions may generate corresponding signals which are, for example, sent to the controller 50 or a signal processing system (not shown), e.g. to construct images of the corresponding scanned areas of the sample 250.

Although **FIG. 4** shows that the electron beam tool 40 uses three primary electron sub-beams, it is appreciated that the electron beam tool 40 may use two or more number of primary electron sub-beams. The present disclosure does not limit the number of primary electron beams used in the electron beam tool 40.

Any element or collection of elements may be replaceable or field replaceable within the electron beam tool 40. The one or more electron-optical components in the electron beam tool 40, especially those that operate on sub-beams or generate sub-beams, such as aperture arrays and manipulator arrays may comprise one or more MEMS.

A non-transitory computer readable medium may be provided that stores instructions for the image processor (such as the controller 50 of FIG. 2) to carry out an electron beam generation, signal electron detection, generation of detection signals from the pixels conveying spatial distribution information of the signal electrons, image processing, or other functions and methods consistent with the present disclosure, etc. Common forms of non-transitory media include, for example, a floppy disk, a flexible disk, hard disk, solid state drive, magnetic tape, or any other magnetic data storage medium, a Compact Disc Read Only Memory (CD-ROM), any other optical data storage medium, any physical medium with patterns of holes, a Random Access Memory (RAM), a Programmable Read Only Memory (PROM), and Erasable Programmable Read Only Memory (EPROM), a FLASH-EPROM or any other flash memory, Non-Volatile Random Access Memory (NVRAM), a cache, a register, any other memory chip or cartridge, and networked versions of the same.

It will be appreciated that the embodiments of the present disclosure are not limited to the exact construction that has been described above and illustrated in the accompanying drawings, and that various modifications and changes may be made without departing from the scope thereof. The present disclosure has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

There are provided a number of clauses:
Clause 1: A charged particle beam apparatus for directing a charged particle beam to preselected locations of a sample surface, the charged particle beam having a field of view of the sample surface, comprising: a charged-particle-optical arrangement configured to direct a charged particle beam along a beam path towards the sample surface and to detect charged particles generated in the sample in response to the charged particle beam; a stage configured to support and move the sample relative to the beam path; and a controller configured to control the charged particle beam apparatus so that the charged particle beam scans over a preselected location of the sample simultaneously with the stage moving the sample relative to the charged-particle-optical column along a route, wherein the charged particle optical arrangement is configured to correct aberrations in the charged particle beam whilst scanning the charged particle beam over the preselected location of the sample.
Clause 2: The charged particle beam apparatus of clause 1, wherein the charged-particle-optical arrangement comprises a deflector arrangement configured to scan the charged particle beam over the preselected location of the sample.
Clause 3: The charged particle beam apparatus of any preceding clause, wherein the charged-particle-optical arrangement comprises a lens arrangement configured to control a focus of the charged particle beam.
Clause 4: The charged particle beam apparatus of clause 3, wherein the lens arrangement is controllable to compensate the aberrations in the charged particle beam, the aberrations comprising off-axis aberrations.
Clause 5: The charged particle beam apparatus of any preceding clause, wherein the charged-particle-optical arrangement comprises a charged-particle-optical component controllable to compensate the aberrations in the charged particle beam, the aberrations comprising astigmatic aberrations generated whilst scanning the charged particle beam over the preselected location of the sample.
Clause 6: The charged particle beam apparatus of any preceding clause, wherein the charged-particle-optical arrangement is configured to generate a signal on detection of a charged particle, the signal being used to generate an image.
Clause 7: The charged particle beam apparatus of any preceding clause, wherein the stage is configured to move continuously, preferably for multiple straight sections of the route.
Clause 8: The charged particle beam apparatus of any preceding clause, wherein the controller is configured to control the charged particle beam apparatus so that the charged particle beam is incident on any location of the sample, preferably so as to generate images of preselected locations of the sample, preferably in order to verify flagged locations as defects.
Clause 9: The charged particle beam apparatus of any preceding clause, wherein the area of the sample covered by the charged particle beam is different for different preselected locations.
Clause 10: The charged particle beam apparatus of any preceding clause, wherein the scan is over the preselected location of the sample covering part of the area of the field of view.
Clause 11: The charged particle beam apparatus of any preceding clause, wherein the field of view comprises multiple preselected locations.
Clause 12: The charged particle beam apparatus of any preceding clause, wherein the controller is configured to control the stage to move the sample in a meandering path relative to the charged-particle-optical arrangement along a meandering route.
Clause 13: The charged particle beam apparatus of clause 12, wherein the meandering route comprises a plurality of straight sections, preferably of at least two of which are parallel, preferably the straight sections extending across the sample.
Clause 14: The charged particle beam apparatus of clause 13, wherein the field of view has a length at least as long as a distance between adjacent straight sections in a direction perpendicular to the straight sections.
Clause 15: The charged particle beam apparatus of clause 13 or 14, wherein the stage is configured to move the sample relative to the charged-particle-optical arrangement at different speeds for different straight sections and/or within a straight section.
Clause 16: The charged particle beam apparatus of clause 15, wherein the stage speed set for a straight section, or a portion of a straight section, is dependent on the number of preselected locations along the straight section or portion of the straight section.
Clause 17: The charged particle beam apparatus of any of clauses 13 to 16, wherein the stage is configured to move the sample relative to the charged-particle-optical arrangement at a constant speed for a straight section or for a portion of a straight section.
Clause 18: The charged particle beam apparatus of any preceding clause, wherein the stage is configured to move the sample relative to the charged-particle-optical arrangement at a constant speed for at least a part of the route.
Clause 19: The charged particle beam apparatus of any preceding clause, configured to direct a plurality of charged particle beams towards the sample.
Clause 20: The charged particle beam apparatus of clause 19, wherein the charged particle beams are independently controllable to simultaneously scan over different preselected locations of the sample.
Clause 21: The charged particle beam apparatus of any preceding clause, wherein preselected locations are determined (or flagged) by optical defect inspection and/or defect prediction, preferably the controller is configured to accept a data file or data signal comprising the preselected locations of a sample and to control the stage and the charged particle arrangement based on the data comprised in the data file or data signal.
Clause 22: A method for directing a charged particle beam to preselected locations of a sample surface, comprising: directing a charged particle beam along a beam path towards a preselected location of a sample, the charged particle beam having a field of view of the sample; moving the sample relative to the beam path; and detecting charged particles emitted from the sample in response to the charged particle beam, wherein the directing the charged particle beam comprises scanning the charged particle beam over a preselected location of the sample simultaneously with the sample being moved relative to the beam path along a route, and correcting aberrations in the charged particle beam whilst scanning the charged particle beam over the preselected location of the sample.
Clause 23: The method of clause 22, comprising using a deflector arrangement to scan the charged particle beam over the preselected location of the sample.
Clause 24: The method of clause 22 or 23, comprising using a lens arrangement to control a focus of the charged particle beam.
Clause 25: The method of clause 24, wherein correcting aberrations comprises controlling the lens arrangement to compensate for off-axis aberrations whilst scanning over the preselected location of the sample.
Clause 26: The method of any of clauses 22-25, wherein correcting aberrations comprises controlling a charged-particle-optical component to compensate for astigmatic aberrations generated whilst scanning over the preselected location of the sample.
Clause 27: The method of any of clauses 22-26, comprising generating a signal on detection of a charged particle, the signal being used to generate an image.
Clause 28: The method of any of clauses 22-27, comprising moving the sample continuously, preferably for multiple straight sections of the route.
Clause 29: The method of any of clauses 22-28, wherein the charged particle beam is incident on the sample so as to generate images of preselected locations of the sample, preferably in order to verify flagged locations as defects.
Clause 30: The method of any of clauses 22-29, wherein the area of the sample covered by the charged particle beam is different for different preselected locations.
Clause 31: The method of clause 30, wherein a size of a preselected location that is scanned over is determined based on an amount of time that a field of view of the sample containing a preselected location is reachable by the charged particle beam and a number of preselected locations in the field of view.
Clause 32: The method of any of clauses 22-31, further comprising scanning the charged particle beam over the preselected location covering a part of an area of the field of view of the sample.
Clause 33: The method of clause 32, wherein the field of view comprises multiple preselected locations.
Clause 34: The method of any of clauses 22-33, comprising moving the sample in a meandering path relative to the beam path along a meandering route.
Clause 35: The method of clause 34, wherein the meandering route comprises a plurality of straight sections, preferably of at least two of which are parallel, preferably the straight sections extending across the sample.
Clause 36: The method of clause 35, wherein the field of view has a length at least as long as a distance between adjacent straight sections in a direction perpendicular to the straight sections.
Clause 37: The method of clause 35 or 36, wherein the sample is moved relative to the beam path at different speeds for different straight sections and/or within a straight section.
Clause 38: The method of clause 37, wherein the stage speed set for a straight section, or a portion of a straight section, is dependent on the number of preselected locations along the straight section or portion of the straight section.
Clause 39: The method of any of clauses 35-38, wherein the sample is moved relative to the beam path at a constant speed for a straight section or for a portion of a straight section.
Clause 40: The method of any of clauses 22-39, wherein the sample is moved relative to the beam path at a constant speed for at least a part of the route.
Clause 41: The method of any of clauses 22-40, comprising directing a plurality of charged particle beams towards the sample.
Clause 42: The method of clause 41, wherein the charged particle beams are independently controlled to simultaneously scan over different preselected locations of the sample.
Clause 43: The method of any of clauses 22-42, comprising: optically illuminating the sample so as to select the locations of the sample to be scanned over by the charged particle beam, the selected locations being said preselected locations.
Clause 44: The method of clause 43, comprising: storing the preselected locations in a data file to be uploaded to a charged particle beam apparatus configured to direct a charged particle beam to the preselected locations stored in the data file.
Clause 45: A charged particle beam apparatus for directing a charged particle beam to preselected locations on a sample surface, comprising: a charged-particle-optical arrangement configured to direct a charged particle beam along a beam path towards the sample surface and to detect charged particles generated in the sample in response to the charged particle beam; a stage configured to support and move the sample relative to the beam path; and a controller configured to control the charged particle beam apparatus so that the charged particle beam scans over the preselected locations of the sample simultaneously with the stage moving the sample relative to the beam path along a meandering route wherein the stage is moved continuously for multiple straight sections of the meandering route, wherein at least two of the straight sections of the meandering route are parallel and the field of view has a length at least as long as a distance between adjacent straight sections in a direction perpendicular to the straight sections..
Clause 46: The charged particle beam apparatus of clause 45 wherein the charged particle optical arrangement is configured to correct aberrations dynamically in the charged particle beam.
Clause 47: The charged particle beam apparatus of clause 46, wherein the charged particle optical arrangement is configured to correct aberrations dynamically in the charged particle beam when scanning the different preselected locations.
Clause 48: The charged particle beam apparatus of clauses 46 or 47, wherein, when scanning different preselected locations, the aberration correction applied to the beam is different.
Clause 49: The charged particle beam apparatus of clauses 46 to 48, wherein the charged particle optical arrangement is configured to correct aberrations dynamically in the charged particle beam to counteract the wafer stage movement as the beam substantially moves through the field of view.
Clause 50: The charged particle beam apparatus of any of clauses 46 to 49, wherein the aberrations that the charged particle optical arrangement is configured to correct dynamically comprise off-axis aberrations whilst scanning over the preselected location of the sample.
Clause 51: The charged particle beam apparatus of any of clauses 46 to 50, wherein the aberrations that the charged particle optical arrangement is configured to correct dynamically comprise astigmatic aberrations generated whilst scanning over the preselected location of the sample.
Clause 52: The charged particle beam apparatus of any of clauses 45 to 51, wherein the charged particle optical arrangement comprises a lens arrangement configured to control a focus of the charged particle beam for correcting aberrations dynamically in the charged particle beam.
Clause 53: A charged particle beam apparatus for directing a charged particle beam to preselected locations on a sample surface comprising: a charged-particle-optical arrangement configured to direct a charged particle beam along a beam path towards the sample surface and to detect charged particles generated in the sample in response to the charged particle beam; a stage configured to support and move the sample relative to the beam path; and a controller configured to control the charged particle beam apparatus so that the charged particle beam scans over the preselected locations of the sample simultaneously with the stage moving the sample relative to the beam path along a route wherein the charged particle optical arrangement is configured to correct dynamically aberrations in the charged particle beam.
Clause 54: The charged particle beam apparatus of clause 53, wherein the charged particle optical arrangement is configured to correct dynamically aberrations in the charged particle beam when scanning the different preselected locations.
Clause 55: The charged particle beam apparatus of clause 53 or 54, wherein, when scanning different preselected locations, the aberration correction applied to the beam is different.
Clause 56: The charged particle beam apparatus of any of clauses 53 to 55, wherein the charged particle optical arrangement is configured to correct dynamically aberrations in the charged particle beam to counteract the wafer stage movement as the beam substantially moves through the field of view.
Clause 57: The charged particle beam apparatus of any of clauses 53 to 56, wherein the aberrations comprise off axis aberrations.
Clause 58: The charged particle beam apparatus of clause 57, wherein the off axis aberrations comprise at least one selected from the group consisting of field curvature, astigmatism, distortion and coma.
Clause 59: The charged particle beam apparatus of clause 58, wherein the controller is configured to correct dynamically field curvature by varying a voltage applied to an electrode of the charged-particle-optical arrangement as a function of a position of the beam within the field of view.
Clause 60: The charged particle beam apparatus of clause 58 or 59, wherein the charged-particle-optical arrangement comprises a stigmator and the controller is configured to correct dynamically astigmatism by varying settings of the stigmator as a function of a position of the beam within the field of view.
Clause 61: The charged particle beam apparatus of clause 60, wherein the stigmator comprises a multipole system, wherein the controller is configured to vary voltages applied to poles of the multipole system as a function of a position of the beam within the field of view.
Clause 62: The charged particle beam apparatus of any of clauses 58 to 61, wherein the charged-particle-optical arrangement comprises a deflector and the controller is configured to correct dynamically coma by varying a setting of the deflector as a function of a position of the beam within the field of view.
Clause 63: The charged particle beam apparatus of any of clauses 45 to 62, wherein: the charged particle beam has a field of view corresponding to a portion of the sample surface; and a charged particle scan over each preselected location of the sample covers at least a part of the field of view.
Clause 64: A method for directing a charged particle beam to preselected locations of a sample surface, comprising: directing a charged particle beam along a beam path towards a preselected location of a sample, the charged particle beam having a field of view of the sample; moving the sample relative to the beam path; and detecting charged particles emitted from the sample in response to the charged particle beam, wherein the directing the charged particle beam comprises scanning the charged particle beam over a preselected location of the sample simultaneously with the sample being moved relative to the beam path along a meandering route wherein the stage is moved continuously for multiple straight sections of the meandering route, wherein at least two of the straight sections of the meandering route are parallel and the field of view has a length at least as long as a distance between adjacent straight sections in a direction perpendicular to the straight sections..
Clause 65: The method of clause 64, comprising: correcting dynamically aberrations in the charged particle beam.
Clause 66: A method for directing a charged particle beam to preselected locations of a sample surface, comprising: directing a charged particle beam along a beam path towards a preselected location of a sample, the charged particle beam having a field of view of the sample; moving the sample relative to the beam path; and detecting charged particles emitted from the sample in response to the charged particle beam, wherein the directing the charged particle beam comprises scanning the charged particle beam over a preselected location of the sample simultaneously with the sample being moved relative to the beam path along a route and dynamically correcting the charged particle beam for aberrations therein.
Clause 67: The method of any of clauses 64-66, comprising using a deflector arrangement to scan the charged particle beam over the preselected location of the sample.
Clause 68: The method of any of clauses 64-67, comprising focusing a lens arrangement to control a focus of the charged particle beam.
Clause 69: The method of clause 68, comprising controlling the focusing of the lens arrangement to compensate for off-axis aberrations whilst scanning over the preselected location of the sample.
Clause 70: The method of any of clauses 64-69, comprising controlling a charged-particle-optical component to compensate for astigmatic aberrations generated whilst scanning over the preselected location of the sample.
Clause 71: The method of any of clauses 64-70, comprising: optically illuminating the sample so as to select the locations of the sample to be scanned over by the charged particle beam, the selected locations being said preselected locations.
Clause 72: The method of clause 71, comprising: storing the preselected locations in a data file to be uploaded to a charged particle beam apparatus configured to direct a charged particle beam to the preselected locations stored in the data file.
Clause 73: The charged particle beam apparatus of any of clauses 1 to 21 and 45 to 63 wherein the beam is a multi-beam of sub-beams, preferably each sub-beam is individually and/or independently controllable.
Clause 74: The method of any of clauses 22 to 44 and 64 to 72 wherein the beam is a multi-beam of sub-beams, the method comprising controlling the sub-beams individually and/or independently.

The descriptions above are intended to be illustrative, not limiting. Thus, it will be apparent to one skilled in the art that modifications may be made as described without departing from the scope of the claims set out below and the clauses set out above.

## Claims

1. A charged particle beam apparatus for directing a charged particle beam to preselected locations of a sample surface, the charged particle beam having a field of view of the sample surface, comprising:
a charged-particle-optical arrangement configured to direct a charged particle beam along a beam path towards the sample surface and to detect charged particles generated in the sample in response to the charged particle beam;
a stage configured to support and move the sample relative to the beam path; and
a controller configured to control the charged particle beam apparatus so that the charged particle beam scans over a preselected location of the sample simultaneously with the stage moving the sample relative to the charged-particle-optical column along a route,
wherein the charged particle optical arrangement is configured to correct aberrations in the charged particle beam whilst scanning the charged particle beam over the preselected location of the sample.

2. The charged particle beam apparatus of claim 1, wherein the charged-particle-optical arrangement comprises a deflector arrangement configured to scan the charged particle beam over the preselected location of the sample.

3. The charged particle beam apparatus of any preceding claim, wherein the charged-particle-optical arrangement comprises a lens arrangement configured to control a focus of the charged particle beam.

4. The charged particle beam apparatus of claim 3, wherein the lens arrangement is controllable to compensate the aberrations in the charged particle beam, the aberrations comprising off-axis aberrations.

5. The charged particle beam apparatus of any preceding claim, wherein the charged-particle-optical arrangement comprises a charged-particle-optical component controllable to compensate the aberrations in the charged particle beam, the aberrations comprising astigmatic aberrations generated whilst scanning the charged particle beam over the preselected location of the sample.

6. The charged particle beam apparatus of any preceding claim, wherein the charged-particle-optical arrangement is configured to generate a signal on detection of a charged particle, the signal being used to generate an image.

7. The charged particle beam apparatus of any preceding claim, wherein the stage is configured to move continuously, preferably for multiple straight sections of the route.

8. The charged particle beam apparatus of any preceding claim, wherein the controller is configured to control the charged particle beam apparatus so that the charged particle beam is incident on any location of the sample, preferably so as to generate images of preselected locations of the sample, preferably in order to verify flagged locations as defects.

9. The charged particle beam apparatus of any preceding claim, wherein the area of the sample covered by the charged particle beam is different for different preselected locations.

10. The charged particle beam apparatus of any preceding claim, wherein the scan is over the preselected location of the sample covering part of the area of the field of view.

11. The charged particle beam apparatus of any preceding claim, wherein the field of view comprises multiple preselected locations.

12. The charged particle beam apparatus of any preceding claim, wherein the controller is configured to control the stage to move the sample in a meandering path relative to the charged-particle-optical arrangement along a meandering route.

13. The charged particle beam apparatus of any preceding claim, configured to direct a plurality of charged particle beams towards the sample, wherein the charged particle beams are independently controllable to simultaneously scan over different preselected locations of the sample.

14. The charged particle beam apparatus of any preceding claim, wherein preselected locations are determined (or flagged) by optical defect inspection and/or defect prediction, preferably the controller is configured to accept a data file or data signal comprising the preselected locations of a sample and to control the stage and the charged particle arrangement based on the data comprised in the data file or data signal.

15. A method for directing a charged particle beam to preselected locations of a sample surface, comprising:
directing a charged particle beam along a beam path towards a preselected location of a sample, the charged particle beam having a field of view of the sample;
moving the sample relative to the beam path; and
detecting charged particles emitted from the sample in response to the charged particle beam, wherein the directing the charged particle beam comprises scanning the charged particle beam over a preselected location of the sample simultaneously with the sample being moved relative to the beam path along a route, and correcting aberrations in the charged particle beam whilst scanning the charged particle beam over the preselected location of the sample.
